# EUROPEAN PATENT APPLICATION

(11) **EP 2 075 849 A2**
(43) Date of publication of application: **01.07.2009**
(21) Application number: 08254052.7
(22) Date of filing: 18.12.2008
(51) Int. Cl.: H01L 31/0216

(54) **Transparent conductive film and solar cell using the same**

(30) Priority: 26.12.2007 JP 2007335036
(71) Applicant: SANYO Electric Co., Ltd., Moriguchi-shi Osaka 570-8677 (JP)
(72) Inventor: Saita, Atsushi, Moriguchi-shi Osaka 570-8677 (JP); Terakawa, Akira, Moriguchi-shi Osaka 570-8677 (JP); Yata, Shigeo, Moriguchi-shi Osaka 570-8677 (JP)
(74) Representative: Calderbank, Thomas Roger

(57) **Abstract**

The transparent conductive film 4 provided to the solar cell 10 includes the oxide of the first element α, the second element β doped into the oxide of the first element α, and the third element γ doped into the oxide of the first element α. The bond distance between the second element β and oxygen O is shorter than the bond distance between the first element α and oxygen O. The bond distance between the third element γ and oxygen O is longer than the bond distance between the fist element α and oxygen O.

## Description

The present invention relates to a transparent conductive film having an improved crystallinity and to a solar cell using the transparent conductive film.

Conventionally, a transparent conductive film formed of indium tin oxide (ITO) , zinc oxide (ZnO) or the like has been used in: display devices, such as an LCD device and an EL display device; photovoltaic devices, such as a solar cell and a photo sensor; semiconductor devices, such as a thin film transistor (TFT); and optical communication devices, such as an optical modulator and an optical switch.

In a solar cell, for example, the transparent conductive film is used as an electrode for extracting photogenerated carriers from a photoelectric conversion layer that generates photogenerated carriers upon receiving light. Specifically, the transparent conductive film is formed either on a light-receiving surface of the photoelectric conversion layer or on a back surface provided on the opposite side of the light-receiving surface.

In a tandem solar cell having two photoelectric conversion layers, a transparent conductive film is placed between the two photoelectric conversion layers, and serves as a reflective layer that reflects back part of light transmitted through one of the two photoelectric conversion layers, toward the photoelectric conversion layer.

Accordingly, such a transparent conductive film needs to have both a high optical transparency and a high electric conductivity.

To fulfill the needs, Japanese Unexamined Patent Application Publication No. Hei 5-110125 proposes a technique in which the amount of dopant (for example, Al, In, B, or Ga) to enhance electric conductivity of a transparent conductive film is increased in a region of the transparent conductive film close to an interface with a photoelectric conversion layer. With such a technique, it becomes possible to reduce a contact resistance at the interface between the transparent conductive film and the photoelectric conversion layer.

However, in such a region where an increased amount of dopant is doped, significant lattice defect is caused due to the addition of the dopant. This results in lattice strain in the transparent conductive film, causing a decrease in crystallinity of the transparent conductive film.

The present invention has been made in view of the above-described problem. Accordingly, an object of the present invention is to provide a transparent conductive film having an improved crystallinity and a solar cell using the transparent conductive film.

An aspect of the present invention provides a transparent conductive film including: an oxide of a first element; a second element doped into the oxide of the first element; and a third element doped into the oxide of the first element. In the transparent conductive film, the oxide of the first element has optical transparency, the bond distance between the second element and oxygen is shorter than the bond distance between the first element and oxygen, and the bond distance between the third element and oxygen is longer than the bond distance between the first element and oxygen.

According to another aspect of the present invention, the oxide of the first element is preferably zinc oxide.

According to another aspect of the present invention, the second element is preferably boron, and the third element is preferably gallium.

Moreover, another aspect of the present invention provides a solar cell including: a first photoelectric conversion layer configured to generate photogenerated carriers upon receiving light; and a transparent conductive film formed on the first photoelectric conversion layer. In the solar cell, the transparent conductive film include: an oxide of a first element; a second element doped into the oxide of the first element; and a third element doped into the oxide of the first element. In the transparent conductive film, the oxide of the first element has optical transmission properties, the bond distance between the second element and oxygen is shorter than the bond distance between the first element and oxygen, and the bond distance between the third element and oxygen is longer than the bond distance between the first element and oxygen.

According to another aspect of the present invention, the solar cell preferably further includes a second photoelectric conversion layer generating photogenerated carriers upon receiving light. In the solar cell, the transparent conductive film may be placed between the first photoelectric conversion layer and the second photoelectric conversion layer.

### In the drawings:

Fig. 1 is a cross-sectional view of a solar cell 10 according to an embodiment of the present invention.
Fig. 2 is a graph showing relationships between electrical resistivity and absorption coefficient according to Examples of the present invention.

Embodiments of the present invention will be described with reference to the drawings. In the following description of the drawings, identical or similar constituents are designated by identical or similar reference numerals. Note that the drawings are merely schematic and proportions of the dimensions and the like are different from the actual ones. Accordingly, the concrete dimensions and the like should be determined in consideration of the following description of the invention. Moreover, it is needless to say that dimensional relations or proportions may vary among the drawings.

### <Configuration of Solar Cell>

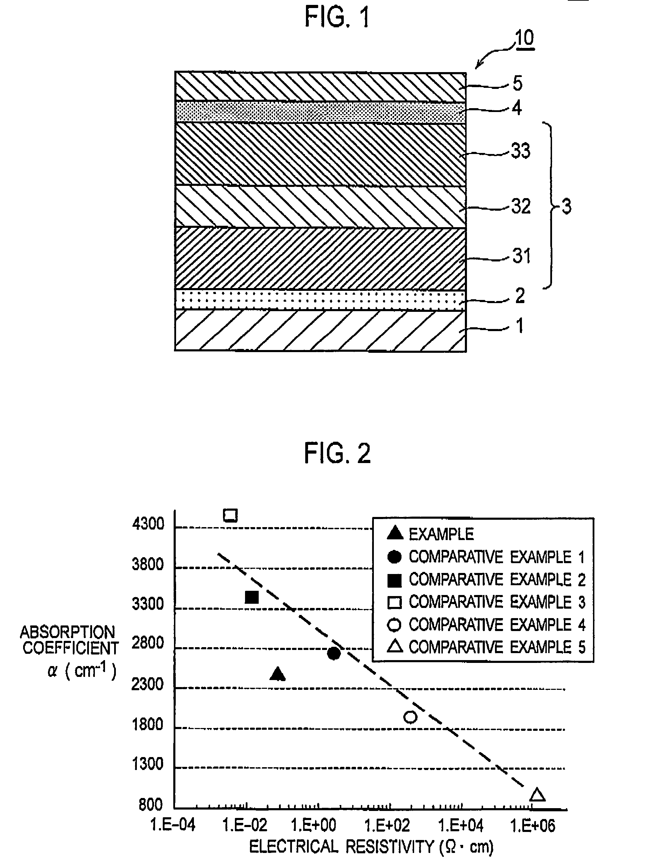

Hereinafter, a configuration of a solar cell 10 according to an embodiment of the present invention will be described with reference to Fig. 1.

Fig. 1 is a cross-sectional view of the solar cell 10 according to the embodiment of the present invention. As shown in Fig. 1, the solar cell 10 includes a substrate 1, a light-receiving-surface electrode layer 2, a photoelectric conversion layer 3, a transparent conductive film 4, and a back-surface electrode layer 5. The light-receiving-surface electrode layer 2, the photoelectric conversion layer 3, the transparent conductive film 4, and the back-surface electrode layer 5 are sequentially stacked on the substrate 1.

The substrate 1 is formed of a light-transmitting material having light transmission properties and electrical insulating properties, such as a glass or a plastic. The substrate 1 has a light-receiving surface and a back surface provided on the opposite side of the light-receiving surface.

The light-receiving-surface electrode layer 2 is stacked on the back surface of the substrate 1. The light-receiving-surface electrode layer 2 serves as a first electrode of the photoelectric conversion layer 3. The light-receiving-surface electrode layer 2 is a transparent conductive film having light transmission properties and electric conductivity. For the light-receiving-surface electrode layer 2, a metal oxide such as tin oxide (SnO₂), zinc oxide (ZnO), indium oxide (In₂O₃) or titanium oxide (TiO₂), can be used. In addition, a metal oxide, of these, doped with fluorine (F), tin (Sn), aluminum (Al), iron (Fe), gallium (Ga), niobium (Nb) or the like may be used.

The photoelectric conversion layer 3 is formed by sequentially stacking a first semiconductor layer 31, a reflective layer 32 and a second semiconductor layer 33 on the light-receiving-surface electrode layer 2.

The first semiconductor layer 31 generates photogenerated carriers upon receiving light entering from the light-receiving-surface electrode layer 2. The first semiconductor layer 31 is formed by sequentially stacking a p-type silicon semiconductor, an i-type amorphous silicon semiconductor and an n-type silicon semiconductor (not shown) on the light-receiving-surface electrode layer 2. Accordingly, the first semiconductor layer 31 has a pin junction.

The reflective layer 32 reflects back part of light transmitted through the first semiconductor layer 31, toward the first semiconductor layer 31. In addition, the reflective layer 32 serves as an electrode electrically connecting the first semiconductor layer 31 and the second semiconductor layer 33. The reflective layer 32 is a transparent conductive film having light transmission properties and electric conductivity, and can be formed of the same material as that of the light-receiving-surface electrode layer 2.

The second semiconductor layer 33 generates photogenerated carriers upon receiving light entering from the reflective layer 32. The second semiconductor layer 33 is formed by sequentially stacking a p-type silicon semiconductor, an i-type microcrystalline silicon semiconductor and an n-type silicon semiconductor (not shown) on the reflective layer 32. Accordingly, the second semiconductor layer 33 has a pin junction.

Here, an amorphous silicon semiconductor and a microcrystalline silicon semiconductor absorb lights having different wavelengths from each other. Accordingly, a tandem solar cell having two kinds of stacked semiconductor layers can effectively utilize sunlight spectrum. Note that the second semiconductor layer 33 is not limited to the above-described microcrystalline silicon semiconductor; alternatively, a single crystal silicon semiconductor or a polycrystalline silicon semiconductor can be used, instead.

The transparent conductive film 4 is stacked on the photoelectric conversion layer 3. The transparent conductive film 4 serves as a second electrode of the photoelectric conversion layer 3. The transparent conductive film 4 can be formed of a base material doped with two or more dopants. Such a base material is a metal oxide having light transmission properties and electric conductivity, such as tin oxide (SnO₂), zinc oxide (ZnO), or indium oxide (In₂O₃). Such dopants improve electric conductivity and crystallinity of the transparent conductive film 4. A detailed configuration of the transparent conductive film 4 will be described later.

The back-surface electrode layer 5 is stacked on the transparent conductive film 4, and serves as the second electrode of the photoelectric conversion layer 3. In addition, the back-surface electrode layer 5 reflects back light transmitted through the second semiconductor layer 33 and the transparent conductive film 4, toward the second semiconductor layer 33. For the back-surface electrode layer 5, a metal material having electric conductivity and high reflectivity, such as aluminum (Al), silver (Ag), or cupper (Cu), can be used.

Here, the light-receiving-surface electrode layer 2, the photoelectric conversion layer 3, the transparent conductive film 4, and the back-surface electrode layer 5 can be sequentially stacked, while patterned by a well known laser patterning method. The laser patterning method allows formation of an integrated solar cell which is composed of multiple solar cell elements electrically connected in series.

### <Configuration of Transparent Conductive Film 4>

The transparent conductive film 4 according to this embodiment includes an oxide of a first element a as a base material. The first element a is selected from Sn, Zn, In, and the like; thus, the base material may be tin oxide (SnO₂), zinc oxide (ZnO), indium oxide (In₂O₃), or the like. In addition, the transparent conductive film 4 is doped with two kinds of dopants, that is, a second element B and a third element Y. The second element B and the third element γ are doped into the oxide of the first element α, and bond to oxygen. Table 1 shows combinations of such an oxide of a first element α, a second element B, and a third element γ.

**[Table 1]**

| Oxide of α | Distance α-O (Å) | β | Distance β-O (Å) | γ | Distance γ-O (Å) |
|---|---|---|---|---|---|
| ZnO | 1.950 | B | 1.363 | Al | 1.971 |
| | | | | Ga | 2.080 |
| | | | | In | 2.170 |
| | | | | Tl | 2.260 |
| SnO₂ | 2.053 | F | 1.405 | Sb | 1.894 to 2.102 |
| | | N | 1.151 | Bi | 2.080 to 2.800 |
| | | P | 1.638 | | |
| | | As | 1.800 | | |
| | | Sb | 1.894 to 2.102 | | |
| In₂O₃ | 2.170 | C | 1.430 | Pb | 2.210 to 2.490 |
| | | Si | 1.609 | | |
| | | Ge | 1.902 | | |
| | | Sn | 2.053 | | |

Table 1 shows the bond distance α-O of the first element a to oxygen O, the bond distance B-O of the second element B to oxygen O, and the bond distance γ-O of the third element γ to oxygen O in each of the oxides of the first elements α.

As shown in Table 1, the distance β-O is shorter than the distance α-O, whereas the distance γ-O is longer than the distance α-O.

### <Method of Producing Solar Cell>

First, the light-receiving-surface electrode layer 2 is formed on the substrate 1 by thermal CVD method or sputtering method. The light-receiving-surface electrode layer 2 is, for example, a SnO₂ film having a thickness of 500 to 800 nm.

Second, the first semiconductor layer 31 is formed by sequentially stacking p-, i-, and n-type amorphous silicon semiconductors on the light-receiving-surface electrode layer 2 by plasma CVD method.

Third, the reflective layer 32 is formed on the first semiconductor layer 31 by sputtering method or film coating method. The reflective layer 32 is, for example, a ZnO film having a thickness of 100 nm or less.

Forth, the second semiconductor layer 33 is formed by sequentially stacking p-, i-, and n-type microcrystalline silicon semiconductors on the reflective layer 32 by plasma CVD method.

Fifth, the transparent conductive film 4 is formed on the second semiconductor layer 33 by RF sputtering method. Specifically, a reaction chamber of an RF sputtering apparatus is pre-evacuated until the inside pressure reaches 3x10⁻⁶ Torr or even below. Next, the reaction chamber is supplied with Ar gas until the inside pressure reaches approximately 3x10⁻³ Torr. Subsequently electricity is simultaneously discharged to both a B-doped ZnO target (BZO) and a Ga-doped ZnO target (GZO) by use of an RF power of 400 W. With this operation, B and Ga are doped into ZnO serving as a base material, and the B and Ga bond to oxygen O in ZnO. Such a transparent conductive film 4 is formed in a thickness of 100 nm or less.

In ZnO, as shown in Table 1, the distance Zn-O of Zn to O is 1.95 Å, the distance B-O of B to O is 1.363 Å, and the distance Ga-O of Ga to O is 2.08 Å. To put it differently, here, when the first element α is Zn, the second element β is B, and the third element γ is Ga, the distance ß-O is shorter than the distance α-O, and the distance γ-O is longer than the distance α-O.

Sixth, the back-surface electrode layer 5 is formed on the transparent conductive film 4 by sputtering method or film coating method. The back-surface electrode layer 5 is, for example, an Ag film having a thickness of 100 to 300 nm.

Note that the light-receiving-surface electrode layer 2, the photoelectric conversion layer 3, the transparent conductive film 4, and the back-surface electrode layer 5 may be patterned by a well-known laser patterning method.

### <Advantageous Effects>

The transparent conductive film 4 provided to the solar cell 10 according to the present invention includes an oxide of the first element α, the second element β, and the third element γ. Both the second element β and the third element γ are doped into the oxide of the first element α. In the transparent conductive film 4, the bond distance ß-O of the second element β to oxygen O is shorter than the bond distance α-O of the first element α to oxygen O, and the bond distance γ-O of the third element γ to oxygen O is longer than the bond distance α-O of the first element α to oxygen O.

Here, if a single kind of dopant is doped into the transparent conductive film with the intention of improving electric conductivity of the film, lattice strain occurs in the transparent conductive film. Presumably, this is because a bond distance X-O of the element of the base material to oxygen in the transparent conductive film is different from a bond distance Y-O of the element of the dopant to oxygen. Specifically, shrinkage strain occurs when the bond distance Y-O is shorter than the bond distance X-O. On the other hand, expansion strain occurs when the bond distance Y-O is longer than the bond distance X-O.

In contrast, two kinds of dopants, that is, the second and third elements, are doped into the oxide of the first element α serving as the base material in this embodiment. Here, the resulting the bond distance ß-O of the second element to oxygen is shorter the distance α-O, whereas the resulting bond distance γ-O of the third element to oxygen is longer than the distance α-O.

Accordingly, the shrinkage strain and the expansion strain in the transparent conductive film can be cancelled against each other, while reducing a contact resistance at the interface between the transparent conductive film 4 and the photoelectric conversion layer 3. As a result, it becomes possible to improve the crystallinity of the transparent conductive film 4.

### <Other Embodiment>

The present invention has been described on the basis of the above-described embodiment. However, it should not be understood that descriptions and drawings constituting one part of this disclosure limit the present invention, and various alternative embodiments, examples, and operational techniques would be apparent for those skilled in the art from this disclosure.

For example, the second and third elements (dopants) are doped into the oxide of the first element in the above-described embodiment. However, three or more kinds of dopants can be used as appropriate.

In the above-described embodiment, the transparent conductive film 4 used in the solar cell 10 is described as an example. However, the above-described transparent conductive film 4 can be applied to: display devices, such as an LCD device and an EL display device; photovoltaic devices, such as a photo sensor; semiconductor devices, such as TFT; optical communication devices, such as an optical modulator and an optical switch.

In the above-described embodiment, the transparent conductive film 4 used in the thin film solar cell 10 is described as an example. However, the transparent conductive film 4 can be applied to general solar cells, such as a crystalline solar cell and a compound semiconductor solar cell.

In the above-described embodiment, the transparent conductive film 4 is described as an example. However, the transparent conductive film 4 may be used as the reflective layer 32 placed between the first semiconductor layer 31 and the second semiconductor layer 33. Accordingly, it becomes possible to improve the crystallinity of the reflective layer 32, while reducing a contact resistance both at the interface between the reflective layer 32 and the first semiconductor layer31, and at the interface between the reflective layer 32 and the second semiconductor layer 33. Moreover, the transparent conductive film 4 may be used as the light-receiving-surface electrode layer 2 placed between the substrate 1 and the first semiconductor layer 31. Accordingly, it becomes possible to improve the crystallinity of the light-receiving-surface electrode layer 2, while reducing the contact resistance at the interface between the light-receiving-surface electrode layer 2 and the photoelectric conversion layer 3.

In the above-described embodiment, the tandem solar cell 10 is described as an example. However, the solar cell 10 may be a solar cell with a single semiconductor layer or with three or more semiconductor layers.

As described above, the present invention obviously includes various other embodiments and the like which are not described herein. Thus, the technical scope of the present invention is only limited by patent claims according to the scope of claims which is valid from the above description.

### <Example>

Hereinafter, a solar cell according to the present invention will be concretely described by way of Example. Note that the present invention is not limited to that to be shown in Example below, and can be implemented with appropriate modifications within a range not departing from the scope of the present invention.

### (Example)

A transparent conductive film according to Example of the present invention was manufactured as follows:

First, a reaction chamber of an RF sputtering apparatus was pre-evacuated until the inside pressure reaches 3x10⁻⁶ Torr. Next, the reaction chamber was supplied with Ar gas until the inside pressure reaches approximately 3x10⁻³ Torr. Subsequently, electricity was simultaneously discharged to both a ZnO target doped 4wt% B₂O₃ (BZO) and a ZnO target doped 4wt% Ga₂O₃ (GZO) by use of an RF power of 400 W. With this operation, B and Ga were doped into ZnO serving as a base material. In this way, a transparent conductive film (GZO + BZO) having a thickness of 100 nm was formed on a glass substrate.

### (Comparative Examples 1 to 3)

Three kinds of transparent conductive films (GZO) with different amounts of Ga were formed by use of a Ga-doped ZnO target (GZO) in an RF sputtering apparatus under the same condition as in Example. Specifically, 2 wt%, 4 wt% and 6 wt% of Ga were respectively doped into the transparent conductive films of Comparative Examples 1 to 3. The thickness of each of the transparent conductive films was 100 nm.

### (Comparative Example 4)

A transparent conductive film of Comparative Example 4 was formed by use of a ZnO target doped B₂O₃ (BZO) in an RF sputtering apparatus under the same condition as in Example. In Comparative Example 4, 4 wt% of B was doped into the transparent conductive film, and the thickness of the film was 100 nm.

### (Comparative Example 5)

A transparent conductive film of Comparative Example 5 was formed by use of a non-doped ZnO target in an RF sputtering apparatus under the same condition as in Example.

(Measurement of absorption coefficient and electrical resistivity)

Absorption coefficient for light with a wavelength of 1000 nm and electrical resistivity of each of the transparent conductive films of Example and Comparative Examples 1 to 5 were measured. The measurement results are shown in Fig. 2, where the longitudinal axis indicates the electrical resistivities while the vertical axis indicates the absorption coefficients. As shown in Fig. 2, it is revealed that the transparent conductive film of Example has both a lower absorption coefficient and a lower electric conductivity than those in Comparative Examples 1 to 5.

This is because the shrinkage strain and the expansion strain were cancelled against each other in the transparent conductive film of Example, and thus the crystallinity thereof was improved. Specifically, as for Example, the cancellation was enabled due to the bond distance between Ga and O longer than that between Zn and O in GZO, and the bond distance between B and O shorter than that between Zn and O in BZO. From these results, it is revealed that the transparent conductive film according to Example can achieve both a high electric conductivity and a high optical transmission property, both of which are important properties for a transparent conductive film.

(Measurement of crystallinity)

A full width at half maximum (FWHM) of a (0002) plane in ZnO of each of the transparent conductive films of Example and Comparative Examples 1 to 5 was measured to compare c-axial orientation properties thereof on a glass substrate with each other. The measurement results are shown in Table 2.

**[Table 2]**

| | Full width at half maximum (deg/riu) |
|---|---|
| Example | 0.7623 |
| Comparative Examples 1 to 3 | 0.8806 |
| Comparative Example 4 | 2.1891 |
| Comparative Example 5 | 0.7120 |

As shown in Table 2, it is revealed that the full width at half maximum of the transparent conductive film according to Example is equivalent to that in Comparative Example 5 (non-doped ZnO). This shows an extremely high crystallinity of the transparent conductive film according to Example. Accordingly, it is revealed that even with dopants, a transparent conductive film having a high crystallinity can be formed by the shrinkage strain and the expansion strain which are cancelled against each other in the transparent conductive film.

## Claims

1. A transparent conductive film comprising:
an oxide of a first element;
a second element doped into the oxide of the first element; and
a third element doped into the oxide of the first element, wherein
the oxide of the first element has optical transmission properties,
a bond distance between the second element and oxygen is shorter than a bond distance between the first element and oxygen, and
a bond distance between the third element and oxygen is longer than the bond distance between the first element and oxygen.

2. The transparent conductive film according to Claim 1, wherein the oxide of the first element is zinc oxide.

3. The transparent conductive film according to Claim 1, wherein
the second element is boron, and
the third element is gallium.

4. A solar cell comprising:
a first photoelectric conversion layer configured to generate photogenerated carriers upon receiving light; and
a transparent conductive film formed on the first photoelectric conversion layer, wherein
the transparent conductive film includes:
an oxide of a first element;
a second element doped into the oxide of the first element; and
a third element doped into the oxide of the first element, the oxide of the first element has optical transmission properties,
a bond distance between the second element and oxygen is shorter than a bond distance between the first element and oxygen, and
a bond distance of the third element and oxygen is longer than the bond distance between the first element and oxygen.

5. The solar cell according to Claim 4, further comprising a second photoelectric conversion layer configured to generate photogenerated carriers upon receiving light, wherein the transparent conductive film is placed between the first photoelectric conversion layer and the second photoelectric conversion layer.
